# EUROPEAN PATENT APPLICATION

(11) **EP 4 839 044 A1**
(43) Date of publication of application: **11.11.2026**
(21) Application number: 26152310.4
(22) Date of filing: 16.01.2026
(51) Int. Cl.: H10B 12/00

(54) **SEMICONDUCTOR DEVICE**

(30) Priority: 09.05.2025 KR 20250060632
(71) Applicant: Samsung Electronics Co., Ltd., Suwon-si, Gyeonggi-do 16677 (KR)
(72) Inventor: LEE, Minyoung, 16677 Suwon-si (KR); KANG, Jongin, 16677 Suwon-si (KR)
(74) Representative: Marks & Clerk LLP

(57) **Abstract**

Provided is a semiconductor device including a substrate including a cell region /CR) and a peripheral region (PR), a first protective pattern (PT1) and a second protective pattern (PT2) disposed on an edge region (CRe) of the cell region, and bit lines (BL) extending along a first direction (D1) on the cell region. The first protective pattern includes a first part (P1) extending along a second direction (D2) substantially perpendicular to the first direction, and a second part (P2) protruding from the first part, and extending in the first direction. The second part is disposed in plurality, and the plurality of the second parts are spaced apart from one another in the second direction, and the second protective pattern and the second parts are alternately disposed along the second direction.

## Description

### FIELD

The present disclosure herein relates to a semiconductor device, and more particularly, to a semiconductor device and a method for manufacturing the same.

### BACKGROUND

A semiconductor device is attracting attention as an important component in the electronics industry due to characteristics thereof such as miniaturization, multi-functionality, and/or low manufacturing cost. The semiconductor device may be classified into a semiconductor memory device that stores a logic data, a semiconductor logic device that calculates and processes the logic data, and a hybrid semiconductor device that includes a memory component and a logic component.

Recently, with a high speed and low power consumption of an electronic apparatus, a high operation speed and/or a low operation voltage are/is also required for the semiconductor device built therein. In order to satisfy such requirements, the semiconductor device becomes more highly-integrated. When the semiconductor device becomes more highly-integrated, reliability of the semiconductor device may be deteriorated. However, with high development of the electronics industry, the reliability of the semiconductor device is highly required. Accordingly, much research on improvement of the reliability of the semiconductor device is being conducted.

### SUMMARY

The present disclosure provides a semiconductor device with improved difficulty in a manufacturing process, and a method for manufacturing the same.

A technical goal of the disclosed concepts is not limited to the goal mentioned above, and other technical goals that are not mentioned may be clearly understood from description below by those skilled in the art.

Embodiments of the disclosed concepts provide a semiconductor device including a substrate including a cell region and a peripheral region, a first protective pattern and a second protective pattern on an edge region of the cell region, and bit lines extending along a first direction on the cell region, wherein the first protective pattern includes a first part extending along a second direction substantially perpendicular to the first direction, and a second part protruding from the first part, and extending in the first direction, the second part is disposed in plurality, and the plurality of the second parts are spaced apart from one another in the second direction, and the second protective pattern and the second parts are alternately disposed along the second direction.

In embodiments of the disclosed concepts, a semiconductor device includes a substrate including a cell region and a peripheral region, a first protective pattern and a second protective pattern disposed on an edge region of the cell region, and a bit line extending along a first direction on the cell region, wherein the first protective pattern includes a protrusion extending in the first direction, the second protective pattern is disposed, in plurality, spaced apart from the protrusion in a second direction substantially perpendicular to the first direction, the bit line includes a first bit line and a second bit line spaced apart from one another along the second direction, the first bit line includes a first edge portion and a second edge portion spaced apart from one another in the first direction, the second bit line includes a third edge portion and a fourth edge portion spaced apart from one another in the first direction, the first edge portion, the second edge portion, and the fourth edge portion are in contact with the first protective pattern, and the third edge portion is in contact with the second protective pattern.

In embodiments of the disclosed concepts, a semiconductor device includes a substrate including a cell region and a peripheral region, a first protective pattern and a second protective pattern disposed on an edge region of the cell region, bit lines extending along a first direction substantially parallel to an upper surface of the substrate on the cell region, a bit line capping pattern on the bit lines, storage node contacts disposed between the bit lines, landing pads provided on the bit line capping patterns and the storage node contacts, and electrically connected to the storage node contacts, and a capacitor structure provided on the landing pads, and electrically connected to the landing pads, wherein the first protective pattern includes a first part substantially parallel to an upper surface of the substrate, and extending along a second direction substantially perpendicular to the first direction, and second parts extending in the first direction, and protruding from the first part, the second protective pattern and the second parts are alternately disposed along the second direction, the bit lines are disposed between the second parts spaced apart from one another in the second direction, and some of the bit lines disposed between the second parts are in contact with the first protective pattern, and the others are in contact with the first protective pattern and the second protective pattern.

In embodiments of the disclosed concepts, a method for manufacturing a semiconductor device includes preparing a substrate including a cell region and a peripheral region, forming a bit line layer on the cell region, forming a first protective pattern which surrounds the bit line layer on an edge region of the cell region, and which includes an extension and a protrusion protruding from the extension, forming second protective patterns penetrating the extension, and forming bit lines by patterning the bit line layer, wherein the protrusion is provided in plurality along a first direction substantially parallel to an upper surface of the substrate, and the second protective patterns and the protrusion are alternately formed along the first direction.

In embodiments, the second protective patterns may be formed such that a pitch in the first direction of the second protective patterns is the same as a pitch in the first direction of the protrusions.

In embodiments, the forming of the protrusions may include partially removing the bit line layer and filling an insulating material on a region in which the bit line layer is removed.

In embodiments, the method for manufacturing a semiconductor device may further include forming a peripheral word line on the peripheral region before the forming of the first protective pattern.

In embodiments, the second protective pattern may be formed across the cell region and the peripheral region along a second direction substantially perpendicular to the first direction.

At least some of the above and other features of the invention are set out in the claims.

### BRIEF DESCRIPTION OF THE DRAWINGS

The accompanying drawings are included to provide a further understanding of the disclosed concepts, and are incorporated in and constitute a part of this specification. The drawings illustrate embodiments of the disclosed concepts and, together with the description, serve to explain principles of the disclosed concepts. In the drawings:
FIG. 1 is a block diagram of a semiconductor device according to embodiments of the disclosed concepts;
FIG. 2 is a plan view illustrating a semiconductor device according to embodiments of the disclosed concepts, and is an enlarged view corresponding to part CU1 of FIG. 1;
FIG. 3 is an enlarged view of part CU2 of FIG. 2;
FIG. 4 is a cross-sectional view taken along line A-A' of FIG. 3;
FIG. 5 is a cross-sectional view taken along line B-B' of FIG. 3;
FIG. 6 is a cross-sectional view taken along line C-C' of FIG. 3;
FIG. 7 is a cross-sectional view taken along line D-D' of FIG. 3; and
FIGS. 8, 9, 10, 11, 12, 13, 14, 15, 16, 17, 18, 19, 20, 21 and 22 are cross-sectional views illustrating operations for manufacturing a semiconductor device according to some embodiments of the disclosed concepts.

### DETAILED DESCRIPTION

Hereinafter, the disclosed concepts will be described in detail by describing embodiments of the disclosed concepts with reference to the accompanying drawings.

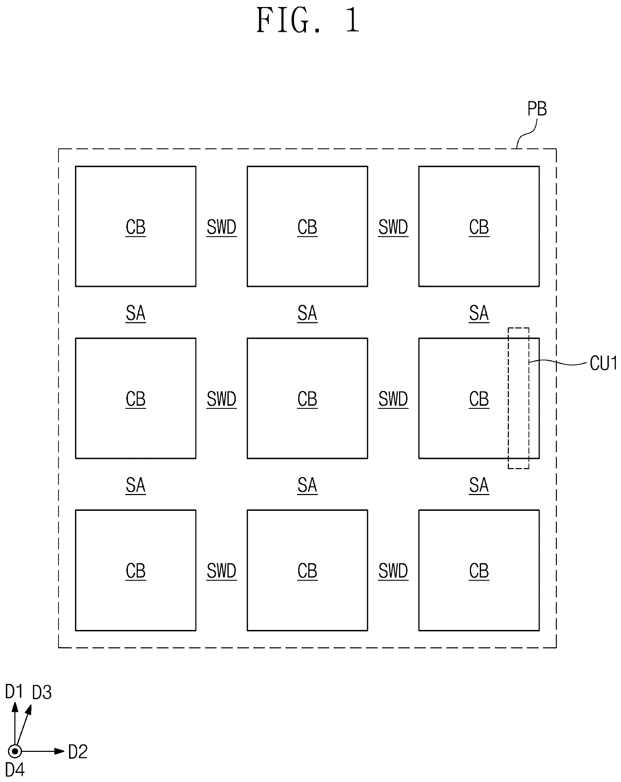

FIG. 1 is a block diagram of a semiconductor device according to embodiments of the disclosed concepts.

Referring to FIG. 1, the semiconductor device may include cell blocks CB and a peripheral block PB surrounding each of the cell blocks CB. The semiconductor device may be a memory device, and each of the cell blocks CB may include a cell circuit such as a memory integrated-circuit. The peripheral block PB may include various peripheral circuits required for operating the cell circuit, and the peripheral circuits may be electrically connected to the cell circuit.

The peripheral block PB may include sense amplifier circuits SA and sub-word line driver circuits SWD. For example, the sense amplifier circuits SA may face one another with the cell blocks CB therebetween, and the sub-word line drivers SWD may face one another with the cell blocks CB therebetween. The peripheral block PB may further include power for driving a sense amplifier, and ground driver circuits, but the disclosed concepts are not limited thereto.

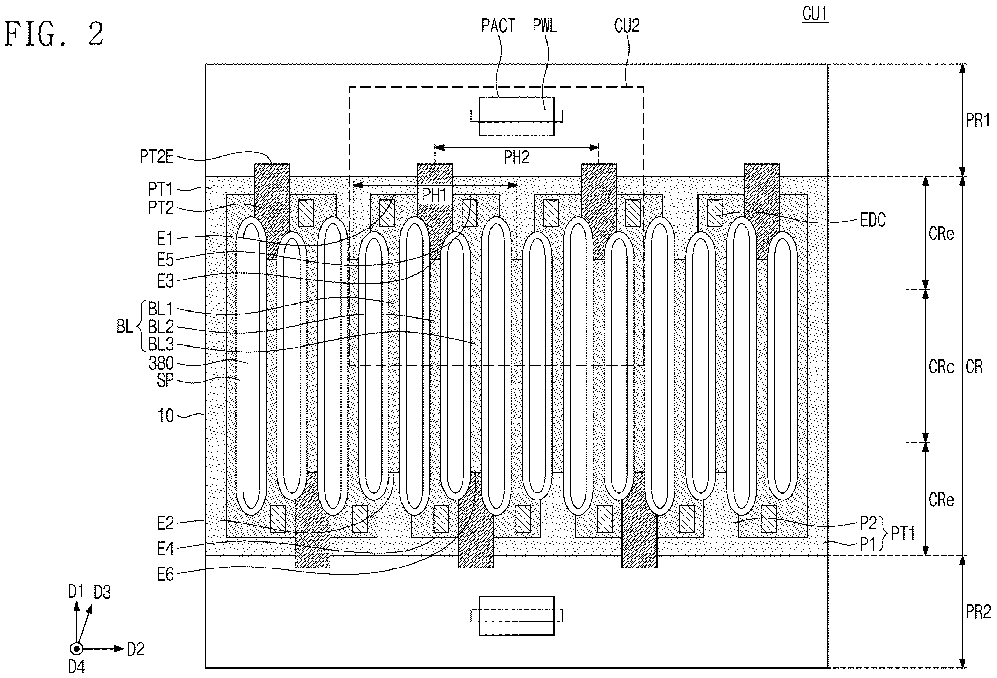

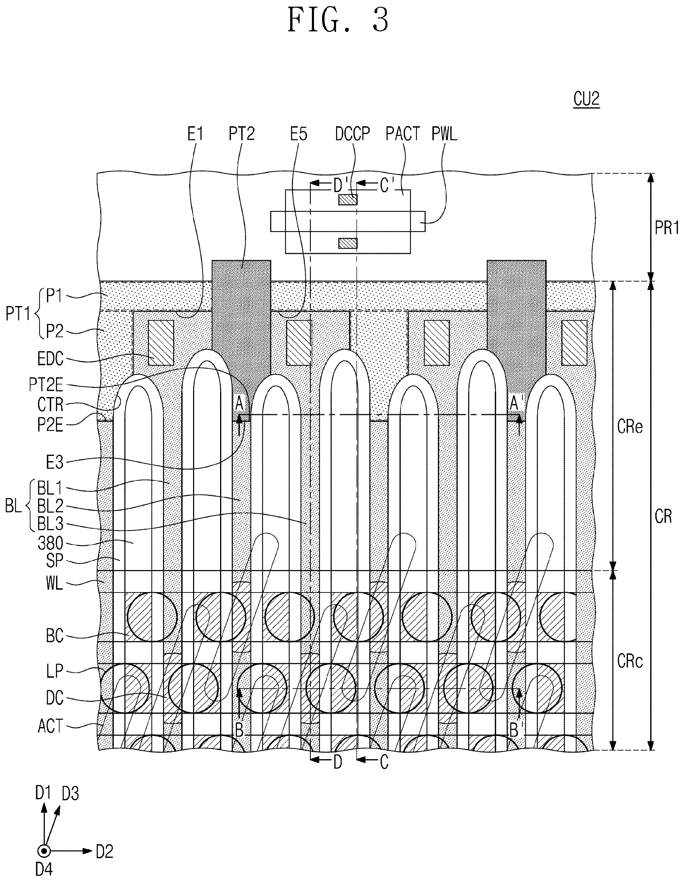

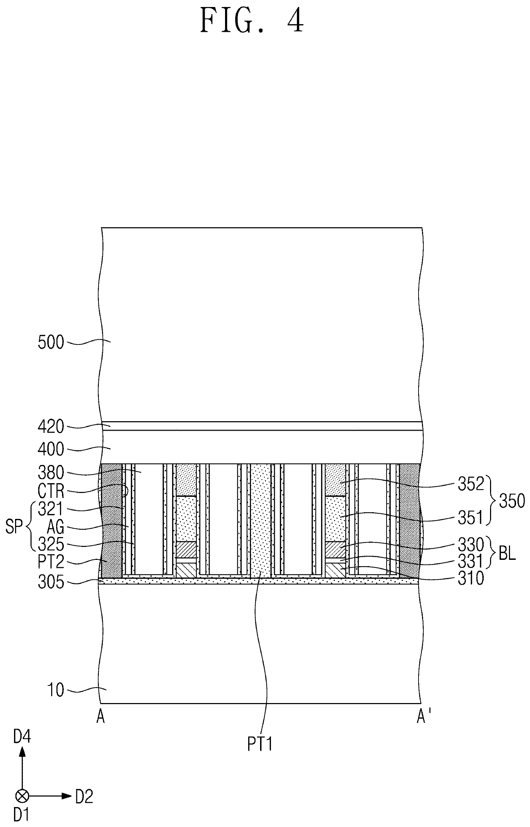

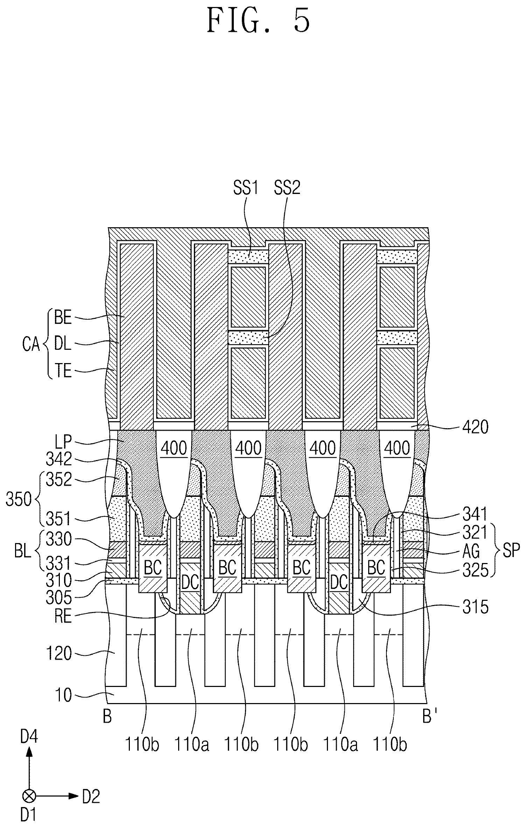

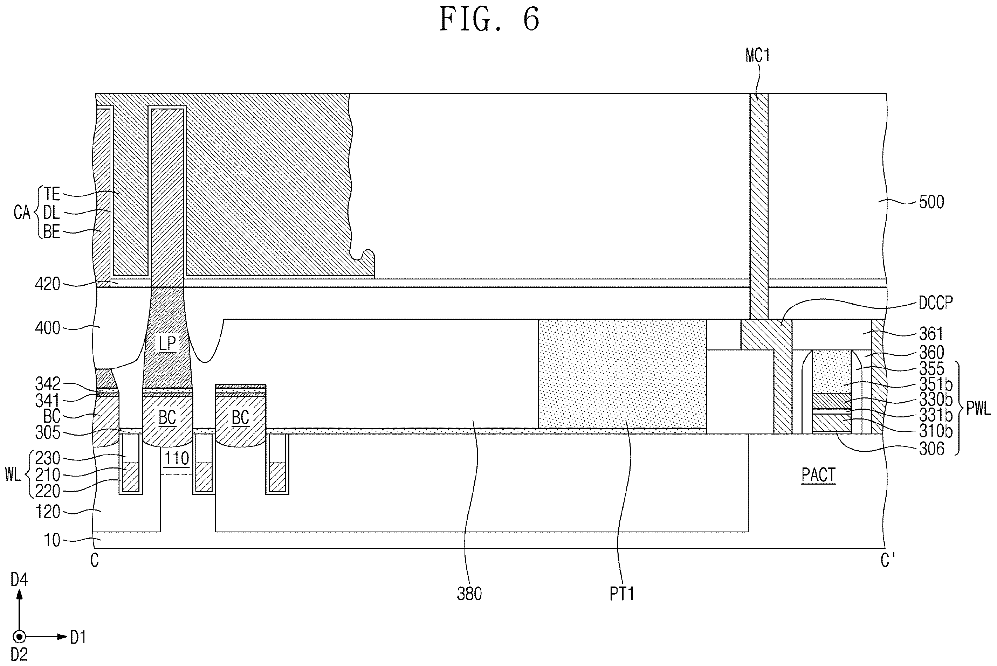

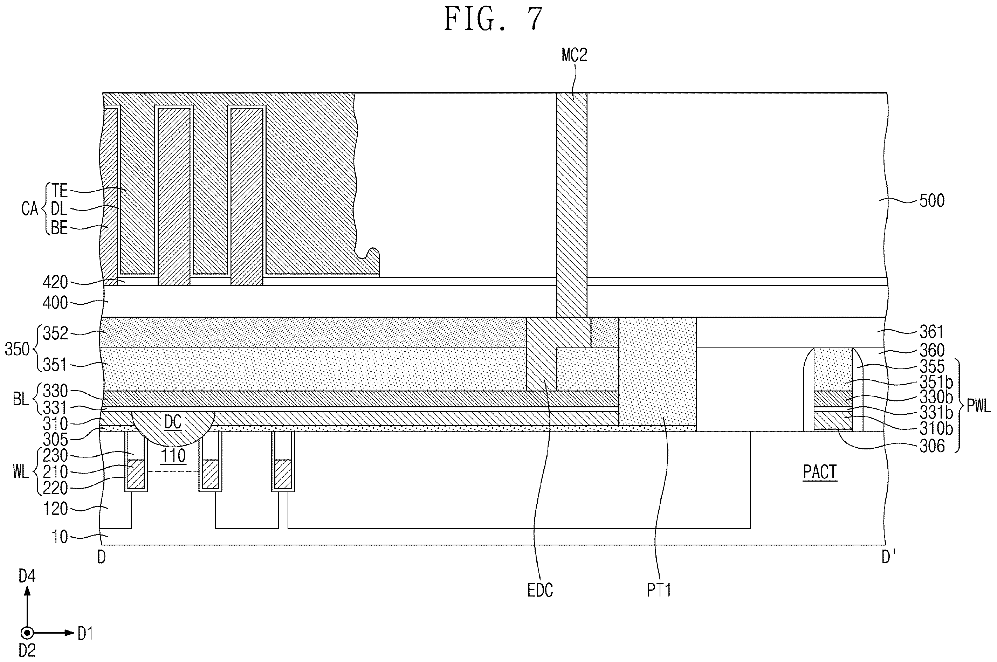

FIG. 2 is a plan view illustrating a semiconductor device according to embodiments of the disclosed concepts, and is an enlarged view corresponding to part CU1 of FIG. 1. FIG. 3 is an enlarged view of part CU2 of FIG. 2. FIG. 4 is a cross-sectional view taken along line A-A' of FIG. 3. FIG. 5 is a cross-sectional view taken along line B-B' of FIG. 3. FIG. 6 is a cross-sectional view taken along line C-C' of FIG. 3. FIG. 7 is a cross-sectional view taken along line D-D' of FIG. 3.

Referring to FIGS. 2 to 7, the semiconductor device according to embodiments of the disclosed concepts may include a substrate 10. For example, the substrate 10 may be a silicon substrate, a germanium substrate, or a silicon-germanium substrate. The substrate 10 may include a cell region CR and a peripheral region PR. The cell region CR may be one region, of the substrate 10, in which each cell block CB of FIG. 1 is provided, and the peripheral region PR may be the other region, of the substrate 10, in which the peripheral block PB of FIG. 1 is provided.

In the present specification, the first direction D1 is defined as one direction perpendicular to an upper surface of the substrate 10. A second direction D2 is defined as one direction parallel to the upper surface of the substrate 10, and perpendicular to the first direction D1. A third direction D3 is defined as one direction parallel to the upper surface of the substrate 10, and crossing the first direction D1 and the second direction D2. A fourth direction D4 is defined as one direction perpendicular to the upper surface of the substrate 10.

The cell region CR may include a center region CRc and edge regions CRe spaced apart from one another in the first direction D1 with the center region CRc therebetween. The edge regions CRe may be a region adjacent to the peripheral region PR. The peripheral region PR may include a first peripheral region PR1 and a second peripheral region PR2 spaced apart from one another in the first direction D1 with the cell region CR therebetween.

As in FIG. 3, cell active patterns ACT may be disposed on the cell region CR of the substrate 10. The cell active patterns ACT may be spaced apart from one another along the first direction D1 and the second direction D2. The cell active patterns ACT may have a form of a bar extending in the third direction D3. The cell active patterns ACT may be arranged such that one end portion of any one among the cell active patterns ACT is adjacent to the center of another cell active pattern ACT next to one another in the second direction D2. Each of the cell active patterns ACT may be a portion of the substrate 10 protruding from the substrate 10 along the fourth direction D4.

Element isolation layers 120 may be disposed between the cell active patterns ACT on the cell region CR. The element isolation layers 120 may be disposed in the substrate 10 to define the cell active patterns ACT. For example, the element isolation layers 120 may include silicon oxide, silicon nitride, and/or silicon oxynitride.

Word lines WL may cross the cell active patterns ACT and the element isolation layers 120 on the cell region CR. The word lines WL may be disposed in grooves formed in the cell active patterns ACT and the element isolation layers 120. The word lines WL may extend in the second direction D2 and may be spaced apart from one another along the first direction D1. The word lines WL may be buried in the substrate 10.

Each of the word lines WL may include a cell gate electrode 210, a cell gate dielectric pattern 220 and a cell gate capping pattern 230. The cell gate dielectric pattern 220 may cover a side surface and a lower surface of the cell gate electrode 210 and a side surface of the cell gate capping pattern 230. The cell gate capping pattern 230 may be provided on an upper surface of the cell gate electrode 210.

The cell gate electrode 210 may include a conductive material. For example, the conductive material may be any one among a doped semiconductor material (doped silicon, doped germanium, etc.), conductive metal nitride (titanium nitride, tantalum nitride, etc.), metal (tungsten, titanium, tantalum, etc.), and a metal-semiconductor compound (tungsten silicide, cobalt silicide, titanium silicide, etc.). For example, the cell gate dielectric pattern 220 may include a silicon oxide layer, a silicon nitride layer, and/or a silicon oxynitride layer. For example, the cell gate capping pattern 230 may include a silicon oxide layer, a silicon nitride layer, and/or a silicon oxynitride layer.

Impurity regions 110 may be provided in the cell active patterns ACT. The impurity regions 110 may include first impurity regions 110a and second impurity regions 110b. The first impurity regions 110a may be provided between a pair of the word lines WL crossing each of the cell active patterns ACT. The second impurity regions 110b may be provided in both edge regions of each of the cell active patterns ACT. The first impurity regions 110a may include an impurity having the same conductive type (for example, an N-type) as the second impurity regions 110b.

A buffer pattern 305 may be disposed on the cell region CR of the substrate 10. The buffer pattern 305 may cover the cell active patterns ACT, the element isolation layers 120 and the word lines WL. For example, the buffer pattern 305 may include silicon oxide, silicon nitride, and/or silicon oxynitride.

Referring to FIGS. 2 and 3, a first protective pattern PT1 and a second protective pattern PT2 may be disposed on the edge region CRe of the cell region CR. On a plan view, the first protective pattern PT1 may surround a boundary of the cell region CR. For example, the first protective pattern PT1 and the second protective pattern PT2 may divide the cell region CR and a peripheral word line PWL to be described later. Alternatively, according to some embodiments, the first protective pattern PT1 may be provided across the cell region CR and the peripheral region PR. Each of the first protective pattern PT1 and the second protective pattern PT2 may include silicon nitride.

The first protective pattern PT1 may include a first part P1 extending along the second direction D2, and a second part P2 protruding from the first part P1 and extending in the first direction D1. In the present specification, the first part P1 and the second part P2 may be respectively referred to as the extension P1 and the protrusion P2. On a plan view, the second part P2 may extend toward the center region CRc of the cell region CR. The second part P2 may be disposed in plurality, and the plurality of second parts P2 may be spaced apart from one another in the second direction D2.

The second protective pattern PT2 may be disposed between the second parts P2 in plurality. Specifically, the second protective pattern PT2 and the second parts P2 may be alternately disposed along the second direction D2. On a plan view, one end PT2E of the second protective pattern PT2 may be aligned with an arbitrary line, of one end P2E of the second part P2, extending in the second direction D2. The second protective patterns PT2 may extend from the cell region CR to a peripheral region along the first direction D1.

As in FIG. 2, the second parts P2 may have a first pitch PH1 in the second direction D2. The second protective patterns PT2 may have a second pitch PH2 in the second direction D2. The first pitch PH1 and the second pitch PH2 may be substantially the same as one another. In the present specification, the first pitch PH1 may correspond to a length in the second direction D2 from a center region of the second part P2 to a center region of another second part P2 nearest thereto in the second direction D2. The second pitch PH2 may correspond to a length in the second direction D2 from a center region of the second protective pattern PT2 to a center region of another second protective pattern PT2 nearest thereto in the second direction D2. For example, each of the first pitch PH1 and the second pitch PH2 may be about 100 nm to about 130 nm.

On a plan view, the second parts P2 adjacent to the first peripheral region PR1 and the second parts P2 adjacent to the second peripheral region PR2 may be arranged in a zigzag form along the second direction D2. The second protective pattern PT2 adjacent to the first peripheral region PR1 and the second protective pattern PT2 adjacent to the second peripheral region PR2 may be arranged in a zigzag form along the second direction D2.

Bit lines BL may be disposed on the cell region CR. The bit lines BL may extend in the first direction D1, and may be spaced apart from one another in the second direction D2.

The bit lines BL may include a first bit line BL1, a second bit line BL2 and a third bit line BL3 spaced apart from one another in the second direction D2. The first bit line BL1, the second bit line BL2 and the third bit line BL3 may be provided between the second parts P2 adjacent to one another in the second direction D2. That is, for example, a number of the bit lines BL provided between the second parts P2 adjacent to one another in the second direction D2 may be three.

The first bit line BL1 may include a first edge portion E1 and a second edge portion E2 spaced apart from one another in the first direction D1. The second bit line BL2 may include a third edge portion E3 and a fourth edge portion E4 spaced apart from one another in the first direction D1. The third bit line BL3 may include a fifth edge portion E5 and a sixth edge portion E6 spaced apart from one another in the first direction D1. The first edge portion E1 to the sixth edge portion E6 may be located on the edge region CRe of the cell region CR.

The first edge portion E1, the third edge portion E3 and the fifth edge portion E5 may be adjacent to the first peripheral region PR1. The second edge portion E2, the fourth edge portion E4 and the sixth edge portion E6 may be adjacent to the second peripheral region PR2. In this case, the first edge portion E1 and the fifth edge portion E5 may be located nearer to the first peripheral region PR1 than the third edge portion E3. The fourth edge portion E4 may be located nearer to the second peripheral region PR2 than the second edge portion E2 and the sixth edge portion E6.

A width in the second direction D2 of the first edge portion E1 may be greater than a width in the second direction D2 of the first bit line BL1 located on the center region CRc of the cell region CR. A width in the second direction D2 of the fourth edge portion E4 may be greater than a width in the second direction D2 of the second bit line BL2 located on the center region CRc of the cell region CR. A width in the second direction D2 of the fifth edge portion E5 may be greater than a width in the second direction D2 of the third bit line BL3 located on the center region CRc of the cell region CR. That is, on a plan view, the first edge portion E1, the fourth edge portion E4 and the fifth edge portion E5 may have a shape of a hammer.

Some of the bit lines BL disposed between the second parts P2 may be in contact with the first protective pattern PT1, and the others may be in contact with the first protective pattern PT1 and the second protective pattern PT2.

For example, the first edge portion E1 and the second edge portion E2 of the first bit line BL1 may be in contact with the first protective pattern PT1. The third edge portion E3 of the second bit line BL2 may be in contact with the second protective pattern PT2, and the fourth edge portion E4 may be in contact with the first protective pattern PT1. The fifth edge portion E5 of the third bit line BL3 may be in contact with the first protective pattern PT1, and the sixth edge portion E6 may be in contact with the second protective pattern PT2. Specifically, the first edge portion E1, the fourth edge portion E4 and the fifth edge portion E5 may be in contact with the first part P1. The second edge portion E2 may be in contact with the second part P2.

The bit lines BL may include a first ohmic pattern 331 and a metal-containing pattern 330 sequentially stacked. For example, the first ohmic pattern 331 may include metal silicide. For example, the metal-containing pattern 330 may include metal (tungsten, titanium, tantalum or the like). Polysilicon patterns 310 may be interposed between the bit lines BL and the buffer pattern 305.

Bit line capping patterns 350 may be respectively disposed on the bit lines BL. The bit line capping patterns 350 may include a lower capping pattern 351 and an upper capping pattern 352. The bit line capping patterns 350 may extend on the bit lines BL along the first direction D1, and may be spaced apart from one another along the second direction D2.

Bit line spacers SP may be provided on sidewalls of the bit lines BL and sidewalls of the bit line capping patterns 350. The bit line spacers SP may include a first sub-spacer 321 and a second sub-spacer 325 spaced apart from one another by an air gap AG. The first sub-spacer 321 and the second sub-spacer 325 may include the same material. The first sub-spacer 321 and the second sub-spacer 325 may have a multi-layered or a single-layered structure of at least one of a silicon oxide layer, a silicon nitride layer or a silicon oxynitride layer.

Bit line contacts DC may be provided on the center region CRc of the cell region CR. Specifically, the bit line contacts DC may be respectively interposed between the bit lines BL and the first impurity regions 110a. The bit lines BL may be electrically connected to the first impurity regions 110a by the bit line contacts DC. The bit line contacts DC may include polysilicon undoped or doped with an impurity.

The bit line contacts DC may be disposed in a recess region RE. The recess region RE may be provided on upper portions of the first impurity regions 110a or on upper portions of the element isolation layers 120 adjacent thereto. The first sub-spacer 321 and a buried insulating pattern 315 may fill a residual portion in the recess region RE.

As in FIG. 3, connection contacts EDC may be provided on the edge region CRe of the cell region CR. The connection contacts EDC may penetrate the bit line BL. On a plan view, the connection contact EDC may be located between the second part P2 and the second protective pattern PT2. Specifically, the connection contacts EDC may be located adjacent to the first edge portion E1, the fourth edge portion E4 and the fifth edge portion E5. For example, the connection contacts EDC may include a metal-containing material.

Cell trenches CTR may be provided between the bit lines BL. The cell trenches CTR may extend along the first direction D1, and may be spaced apart from one another along the second direction D2. On a plan view, one ends of the cell trenches CTR may be arranged in a zigzag form along the second direction D2.

Filling patterns 380 may fill the insides of the cell trenches CTR covered by the bit line spacer SP. On a plan view, one ends P2E of the second parts P2 and one ends PT2E of the second protective patterns PT2 may be located nearer to the center region CRc of the cell region CR than one ends of the filling patterns 380. As a result, a separation defect of the bit lines BL located in the second parts P2 may be improved. A number of the filling patterns 380 disposed between the second parts P2 spaced apart from one another in the second direction D2 may be greater than a number of the bit lines BL disposed between the second parts P2 spaced apart from one another in the second direction D2. For example, the number of the filling patterns 380 disposed between the second parts P2 spaced apart from one another in the second direction D2 may be four. For example, the filling pattern 380 may include silicon nitride.

Peripheral active patterns PACT may be disposed on the peripheral region PR of the substrate 10. Although not shown, peripheral element isolation layers may be disposed between the peripheral active patterns PACT on the peripheral region PR. The peripheral element isolation layers may be disposed in the substrate 10 to define the peripheral active patterns PACT. Peripheral impurity regions may be provided in the peripheral active patterns PACT.

The peripheral word lines PWL may be disposed on the first peripheral region PR1 and the second peripheral region PR2 of the substrate 10. The peripheral word lines PWL may cross the peripheral active patterns PACT.

Each of the peripheral word lines PWL may include a peripheral polysilicon pattern 310b, a first peripheral ohmic pattern 331b, a peripheral metal-containing pattern 330b, a peripheral capping pattern 351b, a peripheral gate dielectric pattern 306 and a peripheral spacer 355.

The peripheral polysilicon pattern 310b, the first peripheral ohmic pattern 331b, the peripheral metal-containing pattern 330b and the peripheral capping pattern 351b may respectively include the same material as the polysilicon pattern 310, the first ohmic pattern 331, the metal-containing pattern 330 and the lower capping pattern 351, and may cross the peripheral active pattern PACT.

The peripheral gate dielectric pattern 306 may be interposed between the substrate 10 and the peripheral polysilicon pattern 310b. The peripheral spacer 355 may be provided on side surfaces of the peripheral polysilicon pattern 310b, the first peripheral ohmic pattern 331b, the peripheral metal-containing pattern 330b, the peripheral capping pattern 351b and the peripheral gate dielectric pattern 306.

A first peripheral insulating pattern 360 and a second peripheral insulating pattern 361 may be disposed on the peripheral region PR. The first peripheral insulating pattern 360 may cover the peripheral word lines PWL. The second peripheral insulating pattern 361 may cover the first peripheral insulating pattern 360. The first peripheral insulating pattern 360 and the second peripheral insulating pattern 361 may include silicon oxide.

Peripheral contact plugs DCCP may be disposed on both sides of each of the peripheral word lines PWL. Each of the peripheral contact plugs DCCP may sequentially penetrate the second peripheral insulating pattern 361 and the first peripheral insulating pattern 360. The peripheral contact plugs DCCP may include the same material as landing pads LP. For example, the peripheral contact plugs DCCP may include a metal-containing material such as tungsten.

Storage node contacts BC may be disposed between the bit lines BL. The bit line spacer SP may be interposed between the storage node contacts BC and the bit lines BL adjacent thereto. The storage node contacts BC may be spaced apart from one another in the first direction D1 and the second direction D2. The storage node contacts BC may include polysilicon undoped or doped with an impurity. The filling patterns 380 may be provided between the storage node contacts BC next to one another in the second direction D2.

A second ohmic pattern 341 may be disposed on each of the storage node contacts BC. The second ohmic pattern 341 may include metal silicide. A diffusion prevention pattern 342 may conformally cover the first sub-spacer 321, the second sub-spacer 325 and the bit line capping pattern 350. The diffusion prevention pattern 342 may include metal nitride such as a titanium nitride layer and a tantalum nitride layer.

The landing pads LP may be disposed on the diffusion prevention pattern 342. The landing pad LP may include a metal-containing material such as tungsten. Upper portions of the landing pads LP may have a greater width than the storage node contact BC. The upper portions of the landing pads LP may be shifted from the storage node contact BC in the second direction D2. The landing pads LP may be spaced apart from one another in the first direction D1 and the second direction D2.

A first interlayer insulating pattern 400 may be provided between the landing pads LP next to one another. The first interlayer insulating pattern 400 may be in contact with an upper portion of the bit line capping patterns 350, an upper portion of the bit line spacer SP, side surfaces of the landing pads LP and the diffusion prevention pattern 342 not covered by the landing pads LP. As in FIGS. 6 and 7, the first interlayer insulating pattern 400 may be provided on the filling pattern 380, and may extend onto the peripheral region PR. On the peripheral region, the first interlayer insulating pattern 400 may be provided on the second peripheral insulating pattern 361. For example, the first interlayer insulating pattern 400 may include a silicon oxide layer, a silicon nitride layer, and/or a silicon oxynitride layer.

A capacitor structure CA may be disposed on the landing pad LP. The capacitor structure CA may include a lower electrode BE, a dielectric layer DL and an upper electrode TE.

The lower electrodes BE may be respectively disposed on the landing pads LP. The lower electrodes BE may include at least one of polysilicon doped with an impurity, a metal nitride layer such as a titanium nitride layer or a metal layer such as tungsten, aluminum and copper. Each of the lower electrodes BE may have a form of a cylinder, a cylinder with a vacant inside or a cup.

An upper support pattern SS1 may support upper sidewalls of the lower electrodes BE, and a lower support pattern SS2 may support lower sidewalls of the lower electrodes BE. The upper and lower support patterns SS1 and SS2 may include an insulating material such as a silicon nitride layer, a silicon oxide layer and a silicon oxynitride layer.

The dielectric layer DL may cover surfaces of the lower electrodes BE and surfaces of the upper and lower support patterns SS 1 and SS2. For example, the dielectric layer DL may include at least one of a silicon oxide layer, a silicon nitride layer, a silicon oxynitride layer or a high-dielectric layer (for example, a hafnium oxide layer). The upper electrode TE may be disposed on the dielectric layer DL, and may fill a space between the lower electrodes BE. The upper electrode TE may include at least one of polysilicon doped with an impurity, a silicon-germanium layer doped with an impurity, a metal nitride layer such as a titanium nitride layer or a metal layer such as tungsten, aluminum and copper.

An etch stop layer 420 may be provided on the cell region CR, the edge region CRe and the peripheral region PR. The etch stop layer 420 may be provided on the first interlayer insulating pattern 400 between the lower electrodes BE. For example, the etch stop layer 420 may include an insulating material such as a silicon nitride layer, a silicon oxide layer and a silicon oxynitride layer.

On the cell region CR and the peripheral region PR, a second interlayer insulating pattern 500 may be provided on the etch stop layer 420. The second interlayer insulating pattern 500 may cover a side surface of the capacitor structure CA. For example, the second interlayer insulating pattern 500 may include a silicon oxide layer, a silicon nitride layer, and/or a silicon oxynitride layer.

As in FIG. 6, a first metal contact MC1 may penetrate the second interlayer insulating pattern 500 and the first interlayer insulating pattern 400 to be in contact with the peripheral contact plugs DCCP. The first metal contact MC1 may be electrically connected to the peripheral contact plugs DCCP. The first metal contact MC1 may include a conductive material.

As in FIG. 7, a second metal contact MC2 may penetrate the second interlayer insulating pattern 500 and the first interlayer insulating pattern 400 to be in contact with the connection contact EDC. The second metal contacts MC2 may be electrically connected to the connection contact EDC. The second metal contacts MC2 may include a conductive material.

A semiconductor device according to a comparative example includes a protective pattern, and insulating patterns extending from the protective pattern, and respectively individually separating bit lines in order to divide a cell region and a peripheral region. In this case, the insulating patterns are provided adjacent to one another in order to respectively separating the bit lines, and in a process of manufacturing the semiconductor device, a process of forming the insulating patterns is performed in consideration of a small pitch of the insulating patterns. As a result, difficulty and scattering in the process of manufacturing the semiconductor device increase, and a bridge or an electrical defect between the bit lines occurs due to the small pitch of the insulating patterns.

Meanwhile, the semiconductor device according to embodiments of the disclosed concepts may include a first protective pattern surrounding a boundary of the cell region, and composed of an extension and protrusions, and a second protective pattern provided between the protrusions. The protrusions and the second protective pattern may separate the bit lines. In this case, the extension and the protrusions of the first protective pattern may be integrally formed, and the second protective patterns may be separately formed between the protrusions after forming the first protective pattern. That is, the protrusions of the first protective pattern may be integrally formed with the extension before forming the second protective patterns to have a sufficient pitch. As a result, the difficulty and the scattering in the process of manufacturing the semiconductor device may be improved.

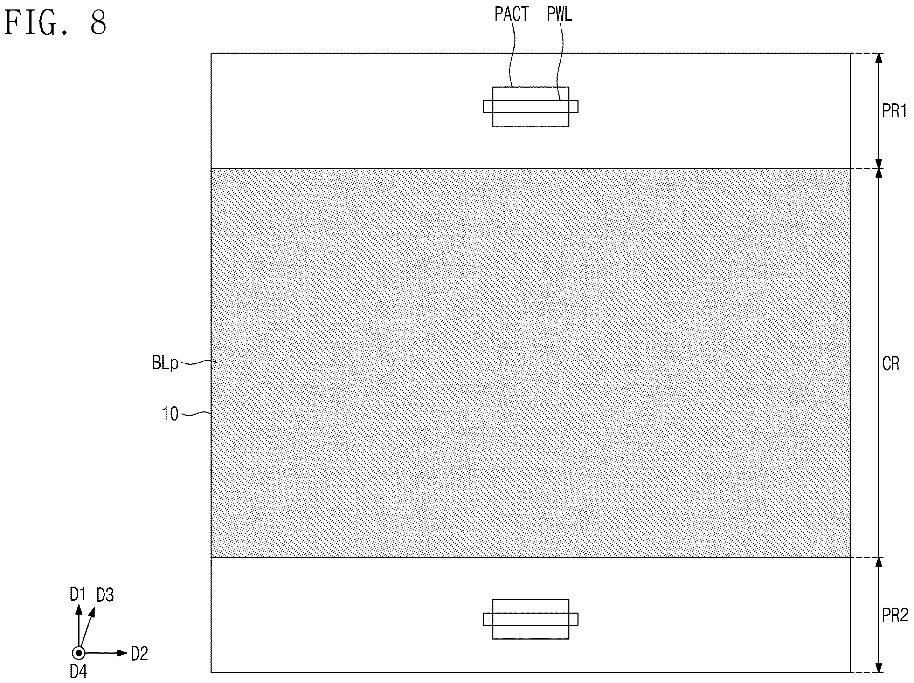

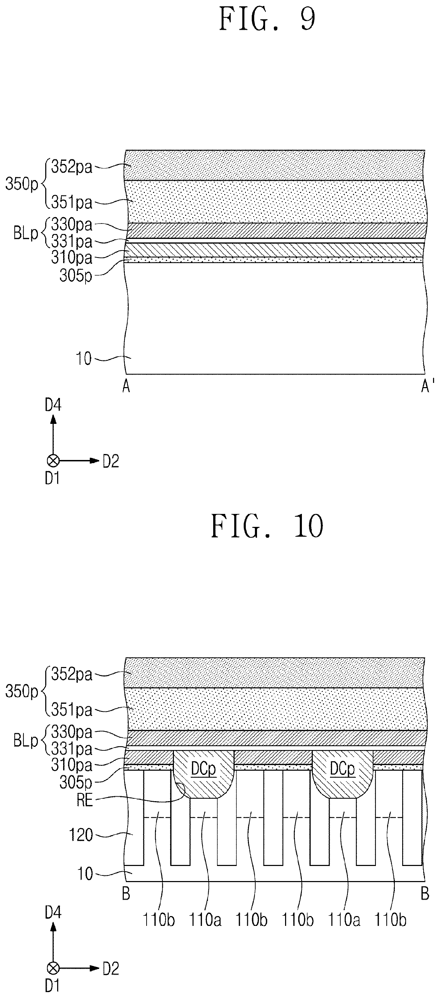

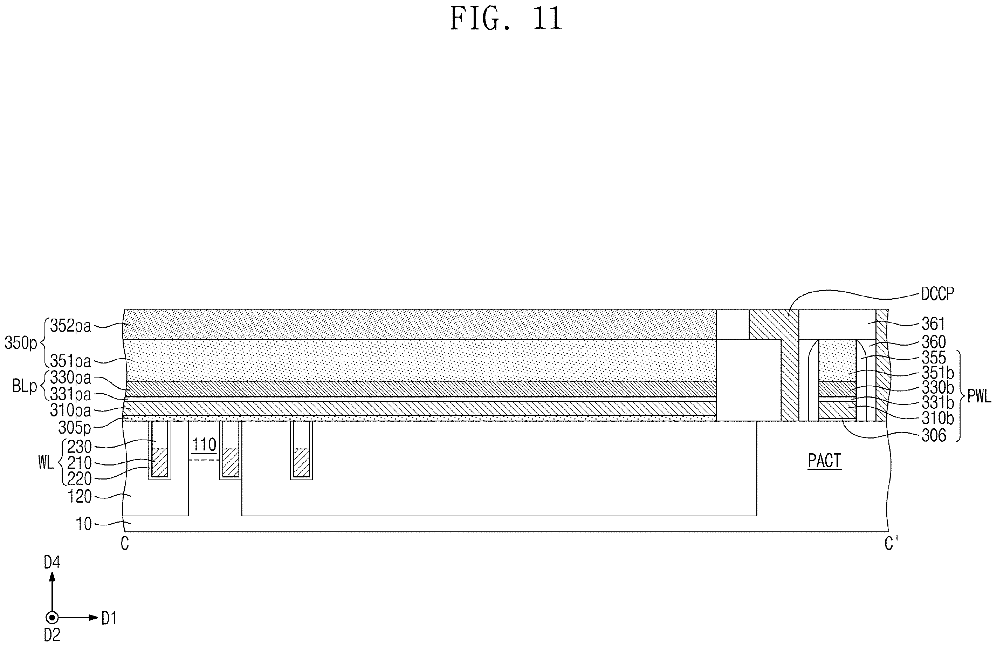

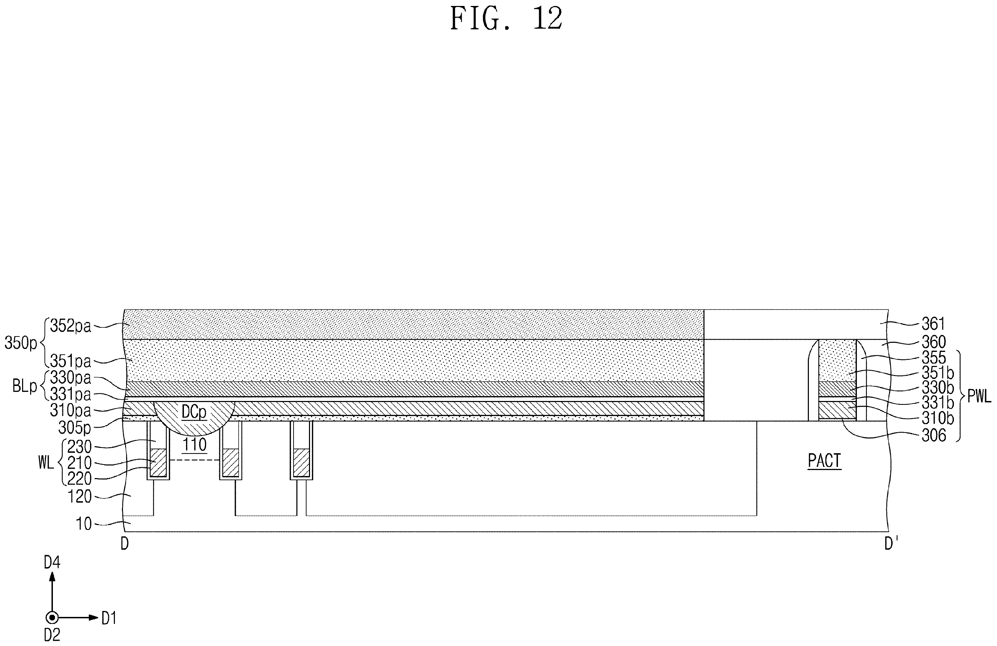

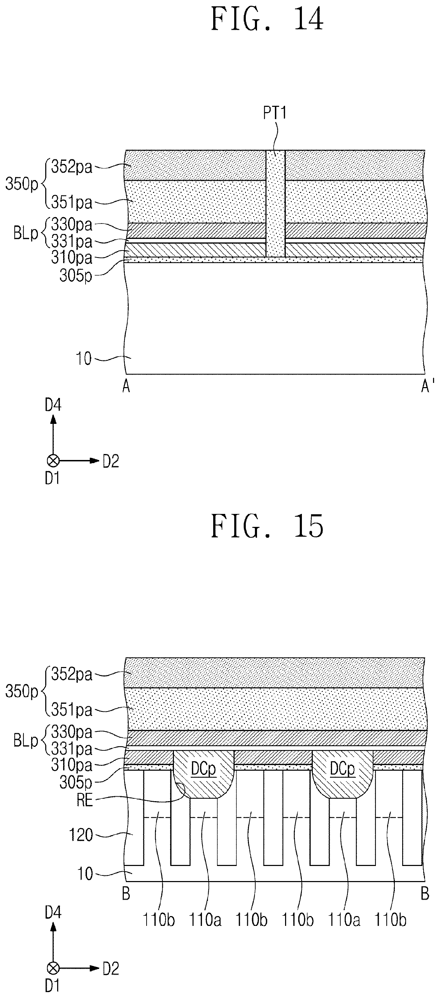

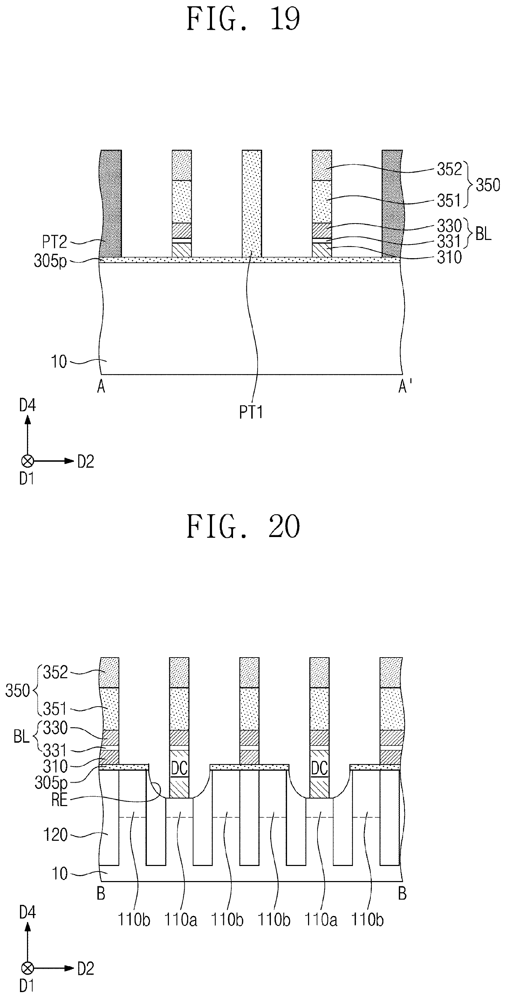

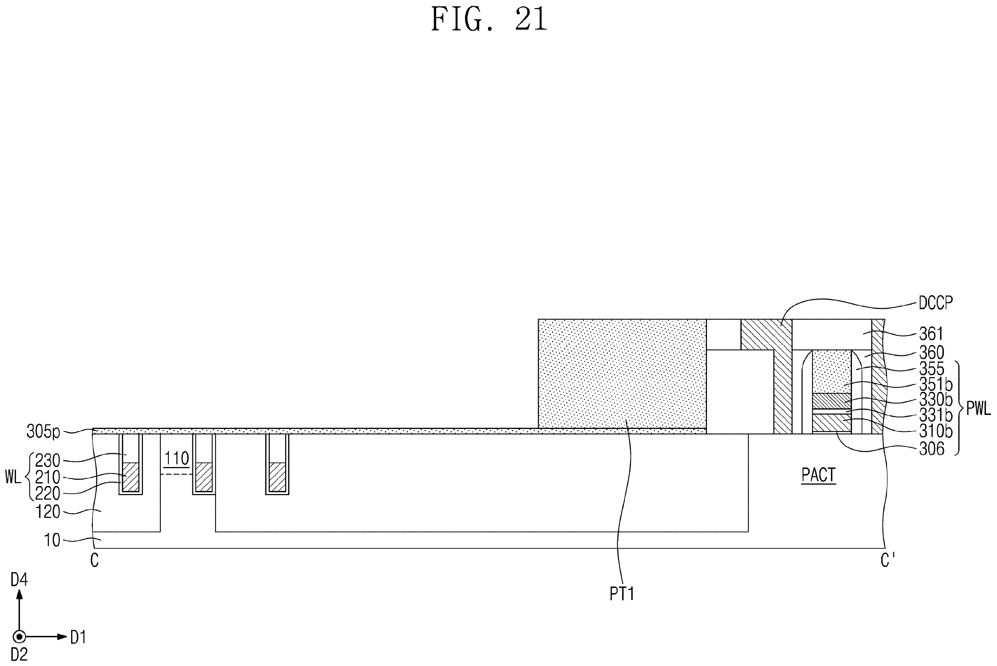

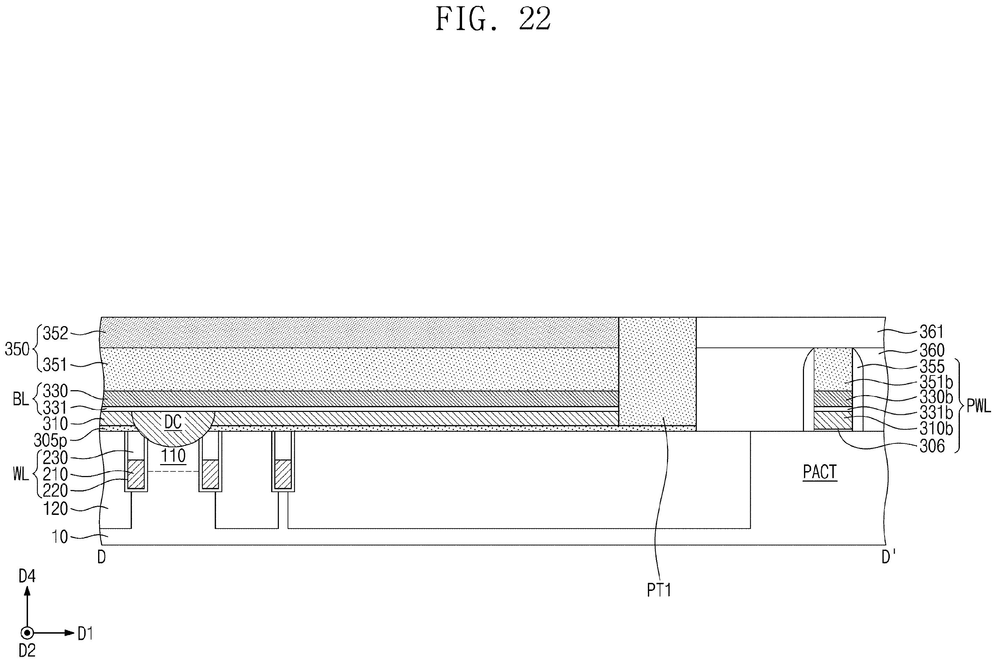

FIGS. 8, 9, 10, 11, 12, 13, 14, 15, 16, 17, 18, 19, 20, 21 and 22 are cross-sectional views illustrating operations for manufacturing a semiconductor device according to some embodiments of the disclosed concepts. Specifically, FIGS. 8, 13 and 18 are cross-sectional views corresponding to FIG. 2. FIGS. 9, 14, and 19 are cross-sectional views taken along line A-A' of FIG. 3. FIGS. 10, 15 and 20 are cross-sectional views taken along line B-B' of FIG. 3. FIGS. 11, 16, and 21 are cross-sectional views taken along line C-C' of FIG. 3. FIGS. 12, 17, and 22 are cross-sectional views taken along line D-D' of FIG. 3.

Referring to FIGS. 3, 8 to 12, the substrate 10 including the cell region CR and the peripheral region PR may be provided. The peripheral region PR may include the first peripheral region PR1 and the second peripheral region PR2 spaced apart from one another in the first direction D1 with the cell region CR therebetween.

The element isolation layers 120 may be formed in the substrate 10 on the cell region CR. The element isolation layers 120 may be disposed in the substrate 10 to define the cell active patterns ACT described in FIG. 3. The word lines WL may be formed so as to cross the cell active patterns ACT and the element isolation layers 120 on the cell region CR. The word lines WL may extend in the second direction D2 and may be spaced apart from one another along the first direction D1. The word lines WL may be buried in the substrate 10. Each of the word lines WL may include the cell gate electrode 210, the cell gate dielectric pattern 220 and the cell gate capping pattern 230.

The impurity regions 110 may be formed in the substrate 10. The impurity regions 110 may include the first impurity regions 110a and the second impurity regions 110b.

A preliminary buffer pattern 305p and a polysilicon layer 310pa may be sequentially stacked on the cell region CR. The recess region RE may be formed on the upper portions of the first impurity regions 110a and on the upper portions of the element isolation layers 120 adjacent thereto. The recess region RE may be formed by etching the preliminary buffer pattern 305p, the polysilicon layer 310pa, the upper portions of the first impurity regions 110a and the upper portions of the element isolation layers 120 adjacent thereto. Preliminary bit line contacts DCp may fill the recess region RE.

An ohmic layer 331pa, a metal-containing layer 330pa, a lower capping layer 351pa and an upper capping layer 352pa may be sequentially stacked on the polysilicon layer 310pa. The ohmic layer 331pa and the metal-containing layer 330pa may form a bit line layer BLp. The lower capping layer 351pa and the upper capping layer 352pa may form a bit line capping pattern layer 350pa. The ohmic layer 331pa may cover upper surfaces of the preliminary bit line contacts DCp.

The peripheral active patterns PACT and the peripheral word lines PWL may be formed on the peripheral region PR of the substrate 10. Each of the peripheral word lines PWL may include the peripheral polysilicon pattern 310b, the first peripheral ohmic pattern 331b, the peripheral metal-containing pattern 330b, the peripheral capping pattern 351b, the peripheral gate dielectric pattern 306 and the peripheral spacer 355.

The first peripheral insulating pattern 360 may be formed on the peripheral region PR, and may cover the peripheral word lines PWL. The second peripheral insulating pattern 361 may be formed on the first peripheral insulating pattern 360. The peripheral contact plugs DCCP may sequentially penetrate the second peripheral insulating pattern 361 and the first peripheral insulating pattern 360 to be formed.

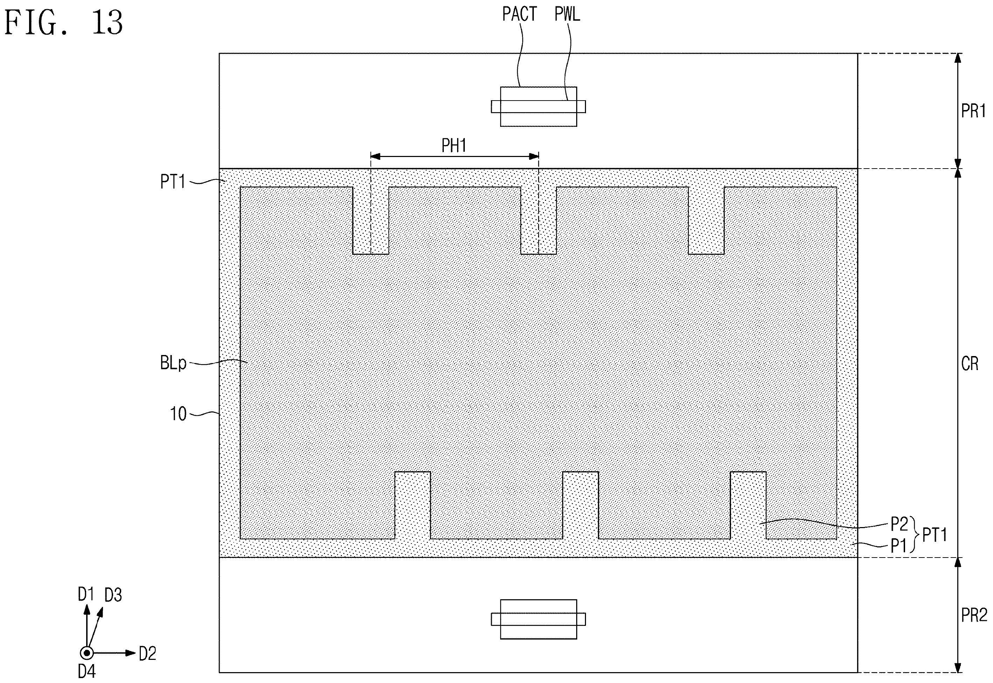

Referring to FIGS. 13 to 17, the first protective pattern PT1 surrounding a boundary of the cell region CR may be formed on the substrate 10. Forming the first protective pattern PT1 may include patterning by partially removing the polysilicon layer 310pa, the bit line layer BLp and the bit line capping pattern layer 350p until an upper surface of the preliminary buffer pattern 305p is exposed, and filling an insulating material on a region in which the polysilicon layer 310pa, the bit line layer BLp and the bit line capping pattern layer 350p are removed.

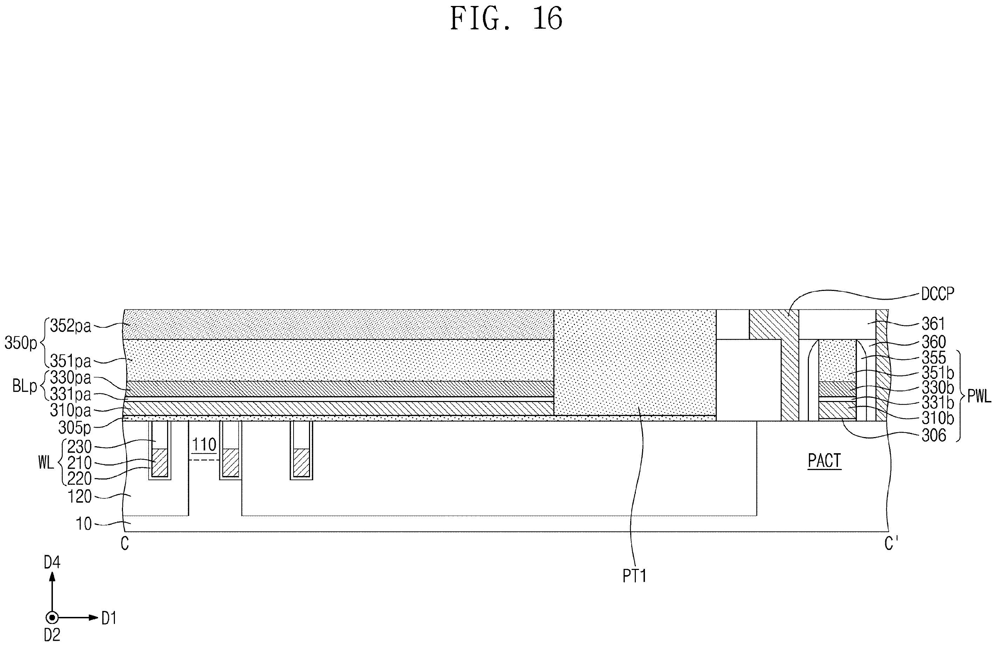

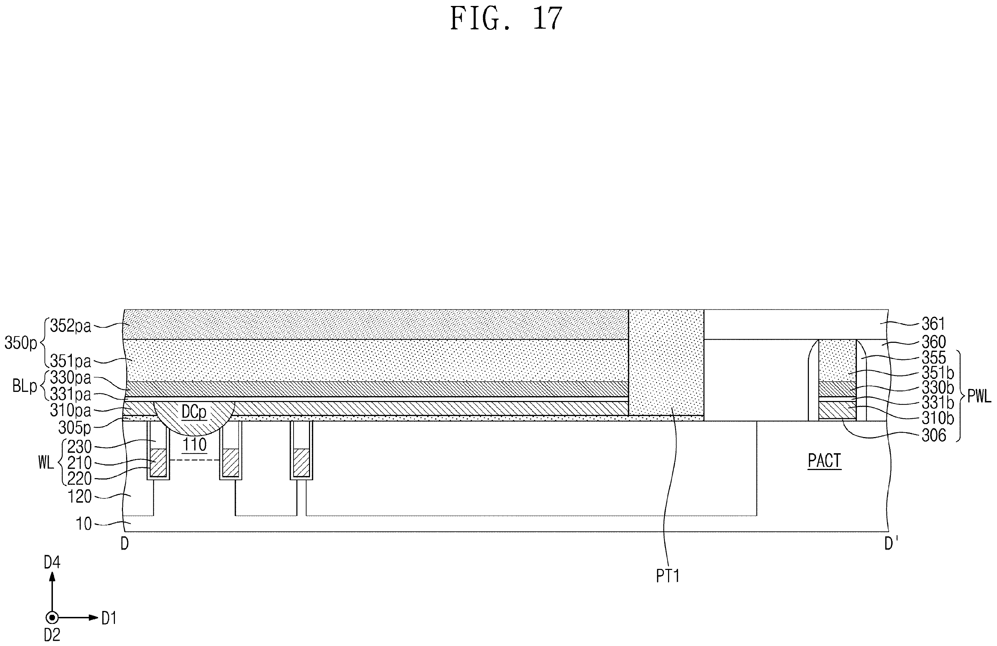

Referring to FIGS. 16 and 17, a side surface of the first protective pattern PT1 may be in contact with a side surface of the bit line layer BLp and a side surface of the bit line capping pattern layer 350p. That is, the first protective pattern PT1 may be formed between the bit line layer BLp and the peripheral word line PWL, and may isolate the same.

In this case, the first protective pattern PT1 may include the first part P1 extending along the second direction D2, and the second part P2 protruding from the first part P1 and extending in the first direction D1. The first part P1 and the second parts P2 may be integrally formed. The second parts P2 may be spaced apart from one another having the first pitch PH1 along the second direction D2. On a plan view, the second parts P2 adjacent to the first peripheral region PR1 and the second parts P2 adjacent to the second peripheral region PR2 may be formed in a zigzag form along the second direction D2.

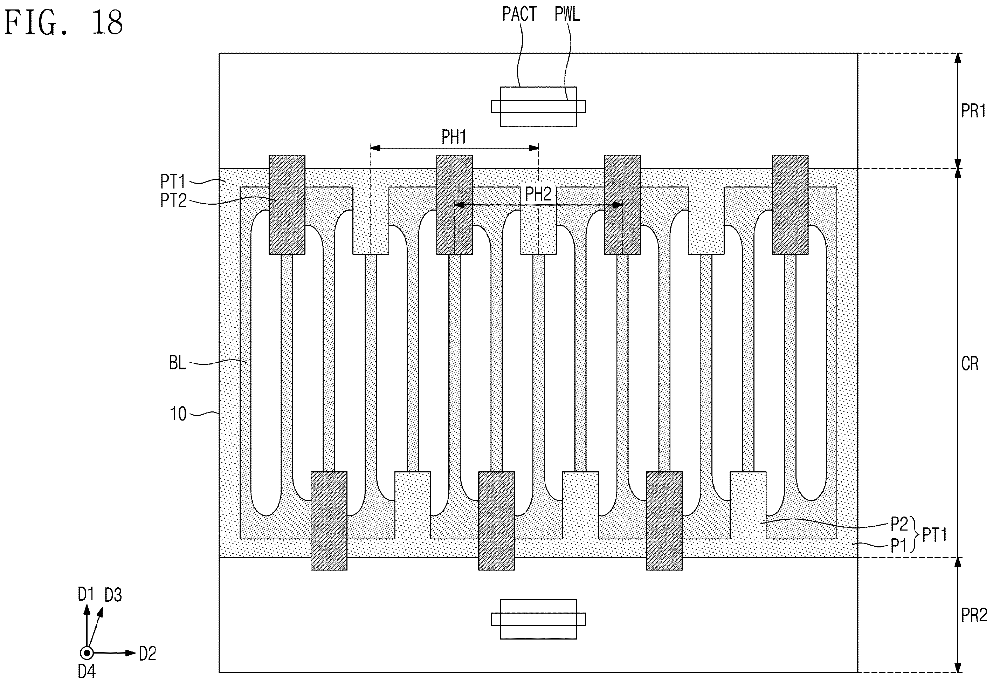

Referring to FIGS. 18 to 22, the second protective pattern PT2 may be formed between the second parts P2 in plurality. Specifically, the second protective pattern PT2 and the second parts P2 may be alternately formed along the second direction D2. That is, the second protective pattern PT2 may be formed separate from the first protective pattern PT1.

The second protective pattern PT2 may be formed across the cell region CR and the peripheral region PR along the first direction D1. In this case, the second protective pattern PT2 may be spaced apart from one another having the second pitch PH2 along the second direction D2. The second pitch PH2 of the second protective patterns PT2 may be substantially the same as the first pitch PH1 of the first parts P1.

Forming the second protective pattern PT2 on the cell region CR may include patterning by partially removing the polysilicon layer 310pa, the bit line layer BLp, the bit line capping pattern layer P1 and the first protective pattern PT1 until the upper surface of the preliminary buffer pattern 305p is exposed, and filling an insulating material on a region in which the polysilicon layer 310pa, the bit line layer BLp, the bit line capping pattern layer P1 and the first part P1 are removed.

Although not shown, forming the second protective pattern PT2 on the peripheral region PR may include patterning by partially removing the first peripheral insulating pattern 360 and the second peripheral insulating pattern 361, and filling an insulating material on a region in which the first peripheral insulating pattern 360 and the second peripheral insulating pattern 361 are removed. Forming the second protective pattern PT2 on the cell region CR and forming the second protective pattern PT2 on the peripheral region PR may be simultaneously performed.

Thereafter, a process of patterning the bit line layer BLp and the bit line capping pattern layer 350p may be performed. As a result of performing the patterning process, the bit line BL and the bit line capping pattern 350 may be respectively formed from the bit line layer BLp and the bit line capping pattern layer 350p. Side surfaces of the bit line contacts DC may be aligned with a side surface of the bit line BL. When the patterning process is performed, the polysilicon layer 310pa and the preliminary bit line contacts DCp may be also patterned to respectively form the polysilicon patterns 310 and the bit line contacts DC.

Referring back to FIGS. 2 to 7, the filling pattern 380 and the storage node contacts BC may be formed. The filling patterns 380 may fill a region in which the bit line layer BLp is removed. The storage node contacts BC may be formed between a pair of bit lines BL next to one another. Each of the storage node contacts BC may be electrically connected to corresponding one among the second impurity regions 110b. During forming the storage node contacts BC, the preliminary buffer pattern 305p may be partially etched to form the buffer pattern 305. The bit line spacer SP may be interposed between the storage node contacts BC and the bit lines BL adjacent thereto.

The second ohmic pattern 341 may be formed on each of the storage node contacts BC. The diffusion prevention pattern 342 may be formed so as to conformally cover the second ohmic pattern 341, the bit line spacer SP and the bit line capping pattern 350. The landing pads LP may be formed on the diffusion prevention pattern 342. Each of the landing pads LP may be electrically connected to corresponding one among the storage node contacts BC. The upper portions of the landing pads LP may be shifted from the corresponding storage node contact BC in the second direction D2.

The connection contacts EDC may penetrate the bit line BL and the bit line capping pattern 350 to be formed. The first interlayer insulating pattern 400 may be formed between the landing pads LP next to one another. The first interlayer insulating pattern 400 may be formed so as to extend onto the cell region CR and the peripheral region PR.

The lower electrodes BE may be respectively formed on the landing pads LP. The etch stop layer 420 may be formed on the cell region CR, the edge region CRe and the peripheral region PR. The etch stop layer 420 may be formed on the first interlayer insulating pattern 400 between the lower electrodes BE. The upper support pattern SS1 may be formed on the upper sidewalls of the lower electrodes BE, and the lower support pattern SS2 may be formed on the lower sidewalls of the lower electrodes BE. The dielectric layer DL may be formed so as to cover the surfaces of the lower electrodes BE and the surfaces of the upper and lower support patterns SS1 and SS2, and the upper electrode TE may be formed on the dielectric layer DL so as to fill a space between the lower electrodes BE. The lower electrode BE, the dielectric layer DL and the upper electrode TE may compose the capacitor structure CA.

The second interlayer insulating pattern 500 may be formed on the cell region CR, the edge region CRe and the peripheral region PR. The second interlayer insulating pattern 500 may be formed on the etch stop layer 420. The second interlayer insulating pattern 500 may be formed so as to cover the side surface of the capacitor structure CA.

The first metal contact MC1 and the second metal contact MC2 may penetrate the first interlayer insulating pattern 400 and the second interlayer insulating pattern 500 to be formed. The first metal contact MC1 may be connected to the peripheral contact plugs DCCP. The second metal contacts MC2 may be connected to the connection contact EDC.

A semiconductor device according to embodiments of the disclosed concepts may include a first protective pattern surround a boundary of the cell region, and composed of an extension and protrusions, and a second protective pattern provided between the protrusions. The protrusions and the second protective pattern may separate bit lines. In this case, the extension and the protrusions of the first protective pattern may be integrally formed, and the second protective patterns may be separately formed between the protrusions after forming the first protective pattern. That is, the protrusions of the first protective pattern may be integrally formed with the extension before forming the second protective patterns to have a sufficient pitch. As a result, difficulty and scattering in a process of manufacturing the semiconductor device may be improved.

Although the embodiments of the present invention have been described it is understood that the present invention should not be limited to these embodiments but various changes and modifications can be made by one ordinary skilled in the art within the scope of the present invention as hereinafter claimed. Therefore, it should be understood that the embodiments described above are examples in all respects and are not intended to be limiting.

Embodiments are set out in the following clauses:
Clause 1. A semiconductor device comprising:
   a substrate including a cell region and a peripheral region;
   a first protective pattern and a second protective pattern disposed on an edge region of the cell region;
   bit lines extending along a first direction substantially parallel to an upper surface of the substrate on the cell region;
   a bit line capping pattern on the bit lines;
   storage node contacts disposed between the bit lines;
   landing pads provided on the bit line capping patterns and the storage node contacts, and electrically connected to the storage node contacts; and
   a capacitor structure provided on the landing pads, and electrically connected to the landing pads,
   wherein the first protective pattern includes:
      a first part substantially parallel to an upper surface of the substrate, and extending along a second direction substantially perpendicular to the first direction; and
      second parts extending in the first direction, and protruding from the first part,
   the second protective pattern and the second parts are alternately disposed along the second direction,
   the bit lines are disposed between the second parts spaced apart from one another in the second direction, and
   some of the bit lines disposed between the second parts are in contact with the first protective pattern, and other bit lines are in contact with the first protective pattern and the second protective pattern.
Clause 2. The semiconductor device of clause 1, wherein a number of the bit lines disposed between the second parts is three.
Clause 3. The semiconductor device of clause 1 or clause 2, further comprising filling patterns disposed between the bit lines, on a plan view,
   wherein a number of the filling patterns disposed between the second parts is greater than a number of the bit lines.
Clause 4. The semiconductor device of any of clauses 1 to 3, wherein the peripheral region comprises a first peripheral region and a second peripheral region spaced apart from one another in the first direction with the cell region therebetween, and
   on a plan view, the second parts adjacent to the first peripheral region and the second parts adjacent to the second peripheral region are arranged in a zigzag form along the second direction.
Clause 5. The semiconductor device of clause 4, wherein on a plan view, the second protective pattern adjacent to the first peripheral region and the second protective pattern adjacent to the second peripheral region are arranged in a zigzag form along the second direction.

## Claims

1. A semiconductor device comprising:
a substrate (10) including a cell region (CR) and a peripheral region (PR);
a first protective pattern (PT1) and a second protective pattern (PT2) on an edge region (CRe) of the cell region (CR); and
bit lines (BL) extending along a first direction (D1) on the cell region (CR),
wherein the first protective pattern (PT1) includes:
a first part (P1) extending along a second direction (D2) substantially perpendicular to the first direction (D1); and
a second part (P2) protruding from the first part (P1), and extending in the first direction (D1),
the second part (P2) is disposed in plurality, and the plurality of the second parts (P2) are spaced apart from one another in the second direction (D2), and
the second protective pattern (PT2) and the second parts (P2) are alternately disposed along the second direction (D2).

2. The semiconductor device of claim 1, wherein the first protective pattern (PT1) and the second protective pattern (PT2) comprise silicon nitride.

3. The semiconductor device of claim 1 or claim 2, wherein:
the second parts (P2) have a first pitch (PH1) in the second direction (D2),
the second protective patterns (PT2) have a second pitch (PH2) in the second direction (D2), and
the first pitch (PH1) and the second pitch (PH2) are the same as one another.

4. The semiconductor device of any preceding claim, wherein:
the second part (P2) extends toward a center region (CRc) of the cell region (CR), and
on a plan view, one end of the second protective pattern (PT2) is aligned with one end of the second part (P2) in the second direction.

5. The semiconductor device of any preceding claim, wherein the second protective patterns (PT2) extend from the cell region (CR) to the peripheral region (PR) along the first direction (D1).

6. The semiconductor device of any preceding claim, further comprising filling patterns (380) disposed between the bit lines (BL),
wherein on a plan view, one ends of the second parts (P2) and first ends of the second protective patterns (PT2) are located nearer to a center region (CRc) of the cell region (CR) than first ends of the filling patterns (380).

7. The semiconductor device of any preceding claim, further comprising cell trenches (CTR) provided between the bit lines (BL), and extending along the first direction (D1),
wherein first ends of the cell trenches (CTR) are arranged in a zigzag form along the second direction (D2).

8. The semiconductor device of any preceding claim, further comprising a connection contact (EDC) disposed on the edge region (CRe) of the cell region (CR),
wherein the connection contact (EDC) is connected to the bit line (BL), and
on a plan view, the connection contact (EDC) is located between the second part (P2) and the second protective pattern (PT2).

9. A semiconductor device comprising:
a substrate (10) including a cell region (CR) and a peripheral region (PR);
a first protective pattern (PT1) and a second protective pattern (PT2) disposed on an edge region (CRe) of the cell region (CR); and
a bit line (BL) extending along a first direction (D1) on the cell region (CR),
wherein the first protective pattern (PT1) includes a protrusion (P2) extending in the first direction (D1),
the second protective pattern (PT2) is disposed, in plurality, spaced apart from the protrusion (P2) in a second direction (D2) substantially perpendicular to the first direction (D1),
the bit line (BL) includes a first bit line (BL1) and a second bit line (BL2) spaced apart from one another along the second direction (D2),
the first bit line (BL1) includes a first edge portion (E1) and a second edge portion (E2) spaced apart from one another in the first direction (D1),
the second bit line (BL2) includes a third edge portion (E3) and a fourth edge portion (E4) spaced apart from one another in the first direction (D1),
the first edge portion (E1), the second edge portion (E2), and the fourth edge portion (E4) are in contact with the first protective pattern (PT1), and
the third edge portion (E3) is in contact with the second protective pattern (PT2).

10. The semiconductor device of claim 9, wherein:
the first protective pattern (PT1) further comprises an extension (P1) connected to the protrusion (P2), and extending in the second direction (D2),
the first edge portion (E1) and the fourth edge portion (E4) are in contact with the extension (P1), and
the second edge portion (E2) is in contact with the protrusion (P2).

11. The semiconductor device of claim 9 or claim 10, wherein:
the first edge portion (E1) is located nearer to the peripheral region (PR) than the third edge portion (E3), and
the fourth edge portion (E4) is located nearer to the peripheral region (PR) than the second edge portion (E2).

12. The semiconductor device of any of claims 9-11, wherein a width in the second direction (D2) of the first edge portion (E1) is greater than a width in the second direction (D2) of the first bit line (BL1) located on a center region (CRc) of the cell region (CR).

13. The semiconductor device of any of claims 9-12, wherein:
the bit line (BLL) comprises a third bit line (BL3) spaced apart from the first bit line (BL1) and the second bit line (BL2) in the second direction (D2),
the third bit line (BL3) comprises a fifth edge portion (E5) and a sixth edge portion (E6) spaced apart from one another in the first direction (D1),
the fifth edge portion (E5) is in contact with the first protective pattern (PT1), and
the sixth edge portion (E6) is in contact with the second protective pattern (PT2).

14. The semiconductor device of claim 13, wherein:
the protrusion (P2) is provided in plurality along the second direction (D2), and
the first bit line (BL1), the second bit line (BL2) and the third bit line (BL3) are provided between protrusions (P2) adjacent to one another in the second direction (D2).

15. The semiconductor device of claim 13 or claim 14, further comprising a connection contact (EDC) disposed on the edge region (CRe) of the cell region (CR),
wherein the connection contact (EDC) is located adjacent to the first edge portion (E1), the fourth portion (E4) and the fifth edge portion (E5).
